# EUROPEAN PATENT SPECIFICATION

(11) **EP 2 428 106 B1**
(45) Date of publication and mention of the grant of the patent: **15.04.2015**
(21) Application number: 10772346.2
(22) Date of filing: 05.05.2010
(51) Int. Cl.: H05K 7/20, H02B 1/56, H05K 5/02

(54) **A CABINET**
SCHRANK
ARMOIRE

(30) Priority: 05.05.2009 SE 0950307
(43) Date of publication of application: 14.03.2012
(73) Proprietor: Sitetel Sweden AB, 192 07 Sollentuna (SE)
(72) Inventor: KULLBERG, Johan, S-179 75 Skå (SE); THOUR, Krister, S-128 69 Sköndal (SE)
(74) Representative: Engdahl, Stefan
(86) International application number: PCT/SE2010/050499
(87) International publication number: WO 2010/128945

(56) References cited:
- EP-A1- 1 901 599
- WO-A1-99/65284
- US-A- 4 706 739
- US-A- 6 164 369
- US-B1- 6 462 944

## Description

### FIELD OF THE INVENTION

The present invention relates to the field of refrigerating electronic equipment. In particular, the invention relates to a cabinet for the refrigeration of electronic equipment positioned therein.

### BACKGROUND OF THE INVENTION

For the housing of electronic equipment such as e.g. batteries, servers, processors, measuring equipment, telecommunication equipment and optical fibers, cabinets are well known. The benefits of these enclosures are numerous, not only considering an improved order of the equipment, but also due to aspects regarding safety such as protection from theft, fire, leakage and so on. Cabinets are moreover used for shielding or isolating the electronic equipment from external environments having a deteriorating effect thereon. Also, the cabinets may be arranged to cool the electronic equipment. The cabinets may be adapted for an external, outdoor use, where they are typically constructed to be weatherproof so as to minimize the risk of equipment damage.

The improvements in design and construction of electronics, telecommunications and batteries have lead to a development striving towards smaller equipment with an increased power. For batteries, it is known to those skilled in the art that high temperatures within the enclosure tend to decrease the service life of the batteries, necessitating costly servicing and/or battery replacements. In other words, a battery operating in a high-temperature environment may have its lifetime shortened.

One example of an outdoor cabinet to be used in a telecommunication system is disclosed in patent document SE 518304. A climate controlling device is provided in the door and fans are arranged above each of the electronic units situated in the interior of the cabinet, wherein each of the fans removes and forwards heat generated by the units to an internal channel system. The heated air is transported to a heat exchanger which absorbs and forwards the heat via an external flow of air to

the ambient air outside the cabinet. Additional fans blow the cooled air into a space between the door and the cabinet body in front of the electrical equipment.

Another example of a prior art cabinet for controlling the environmental conditions within a telecommunications base station is disclosed in patent document GB 2277767. The temperature of the air within the base station is controlled by apparatus incorporated in or on a door. In use, fans draw external air into the interior of the base station through a louvered panel. The external air passes across the heat exchanger, and the internal air from within the base station is also drawn across the heat exchanger, the air leaving the base station through a second panel.

Further, EP1901599A1 relates to a cooler for a heater-containing box in which an outside air fan for currying air on an outside air path and an inside air fan for carrying air on an inside air path are arranged such that a rotating shaft of each fan is in parallel with an air intake direction, and a heat exchanger for exchanging sensible heat of outside air and inside air is arranged between the outside air path and the inside air path such that a suction port at a longitudinal air-path side of the heat exchanger is aligned with a blowout port of the fan.

WO99/65284A1 discloses a wall or door element or an insert for a wall or door element in a control cabinet, wherein the control cabinet comprises a body for receiving electrical and/or electronic devices, having at least one ventilation device arranged in the wall or door element or in the insert for the wall or door element to suction the air in the switch cabinet. At least one opening is available for suctioning ambient air in the wall or door element or in the insert for the wall or door element. The wall or door element or the insert for a wall or door element has a locating device for a cooling or air-conditioning module.

D3 US6164369A discloses a modular door mounted heat exchanger for use with an outdoor equipment enclosure of the type having a sealed equipment compartment used to house heat generating electronics and telecommunications equipment therein is disclosed. The heat exchanger includes a door panel sized and shaped to be received on, and to close an access opening defined as a part of the equipment enclosure. The door panel has an interior surface for facing inwardly of the enclosure, and an exterior surface for facing outwardly of the enclosure. A heat exchanger cover constructed and arranged to be mounted to the exterior surface of the door panel is provided. The heat exchanger cover defines a plenum between the exterior surface of the door panel and the heat exchanger cover. At least a first opening and at least a spaced second opening are defined within the plenum for defining an air flow path passing within and at least partially along the plenum. At least one fan is provided for drawing air into and exhausting air out of the plenum through the at least first and second openings, respectivey. The fan is constructed and arranged to draw outside air through the plenum for cooling the exterior surface of the door panel, so that the air within the enclosure that comes into contact with the interior surface of the door panel is in turn cooled.

US6462944B1 discloses a computer cabinet cooling system comprising an upright tower cabinet having a front panel with an equipment bay for holding heat producing components, a lower aperture and a pluralitv of air openings. A fan unit having a fan plenum is mounted within the lower aperture of the front panel below the equipment bay near the air openings. An inner door is provided having a plurality of air inlet ports, a plurality of air outlet ports, a plurality of spaced apart horizontal air ingress slots and a fan shroud. When the inner door is closed against the front panel, the air outlet ports will align with the air openings in the front Panel, the air ingress slots will align with the heat producing components in the equipment bay and the fan shroud will contact the fan unit. An outer door is also provided having an air plenum, a lower orifice with air deflector, and a plurality of spaced apart horizontal air ingress slots. When the fan unit is turned on ambient air will be drawn through the air inlet ports and air outlet ports in the inner door, past the air openings in the front panel, into the fan plenum, out through the fan shroud, past the lower orifice with the air deflector, up through the air plenum in the outer door through the air ingress slots in the outer door, past the air ingress slots in the inner door and into the equipment bay in the front panel to cool the heat producing components in the upright tower cabinet.

US4706739A discloses a heat exchanger assembly for cooling the interior of a closed cabinet containing electronic components or the like includes a finned heat pipe core. The core has a plurality of spaced substantially parallel heat bodies as well as a plurality of spaced fins which are provided with colinear apertures through which each of the plurality of heat pipe bodies can extend. The finned heat pipe core is secured to an associated closed cabinet. A pair of fans are provided, one being operatively connected with each end of the finned heat pipe core. One of the fans and an associated first end of the heat pipe core is in contact only with the air inside the associated closed cabinet. The other of the fans and an associated second end of the finned heat pipe core is in contact only with the ambient air outside the associated cabinet. The fins have a spacing and a thickness which is sized to fit the performance curve of the fans

However, there are problems related to the aforementioned structures. The arrangements disclosed do not provide a controlled and evenly distributed cooling or refrigeration throughout the interior of the cabinet.

### SUMMARY OF THE INVENTION

It is an object of the present invention to mitigate the above problems and to provide a cabinet that provides an improved climate control of the electronic equipment contained therein.

This and other objects are achieved by providing a cabinet having the features defined in the independent claim. Preferred embodiments are defined in the dependent claims.

According to a first aspect of the present invention, there is provided a cabinet for refrigerating electronic equipment positioned in a compartment of a cabinet body. The cabinet is further arranged with a cabinet door for closing an access opening to said compartment. When the cabinet door is closed, the cabinet body together with the closed cabinet door encloses the compartment. It is understood that the refrigerating effect can only be achieved when the cabinet door is closed. Also, opening the cabinet door will uncover the access opening, whereby electronic equipment may be positioned therein or, if the electronic equipment is already positioned therein, the electronic equipment or a part thereof may be removed and/or replaced with other electronic equipment.

The term "electronic equipment" should, in this context, be construed as e.g. batteries, servers, processors, measuring equipment, telecommunication equipment, optical fibers or the like. Moreover, the electronic equipment for which the cabinets are provided have different specific operational temperature intervals, e.g. 0-45 °C. In other words, the electronic equipment is intended to operate within a specific operational temperature interval suitable for the function thereof. Also, in addition to the refrigeration of the electronic equipment, some electronic equipment generate heat which needs to be compensated for.

Also, the cabinet is further arranged with at least one partitioning means for partitioning the compartment into at least two sub-compartments. Thus, the space of the compartment is partitioned into at least two smaller compartment spaces, i.e. two sub-compartments. The at least two sub-compartments are in fluid communication, i.e. the partitioning means provide an opening or openings between the sub-compartments. In other words, the partitioning means are arranged such that the sub-compartments are in fluid communication.

It should noted that the term "partitioning means" as used herein is intended to refer to at least a partition or wall or the like which separates or divides the compartment into sub-compartments. Thus, partitioning means may for example be shelves, racks, plates, boards or the like.

Moreover, the cabinet is further arranged with a cooling system, wherein the cooling system is arranged in the cabinet door. The cooling system is in fluid communication with the compartment via a fluid outlet and a fluid inlet. Thus, the fluid inlet and the fluid outlet are in fluid communication with the at least two sub-compartments. The cooling system comprises a fan for discharging cooling fluid via the fluid outlet into at least a first sub-compartment of the at least two sub-compartments. Also, the fan exhausts fluid via at least a second sub-compartment of the at least two sub-compartments through the fluid inlet. Thus, the at least one first sub-compartment is a sub-compartment into which cooling fluid is discharged, whereas the at least one second sub-compartment is a sub-compartment through which the cooling fluid is exhausted. The fan simultaneously causes both a discharging effect and an exhausting effect, thereby contributing to generate a flow inside the compartment. During operation the fan discharges cooling fluid, i.e. exhausted fluid which has been cooled by the cooling system, into and through the at least one first sub-compartment. Thereafter, the cooling fluid continues until it reaches the at least one second sub-compartment and thereafter continues via the fluid inlet back to the cooling system which again cools the exhausted fluid for further discharge. It is understood that if the electronic equipment generates heat, the cooling system is arranged to compensate for this additional heat, thereby providing an optimal operation temperature for the electronic equipment.

It should be noted that the term "discharging cooling fluid" as used herein is intended to refer to a delivery of a cooling fluid into a constrained space, thereby generating a flow in the space. Analogously, the term "exhausting fluid" as used herein is intended to refer to an emptying of a constrained space. In other words, fluid is drawn from a space thereby generating a low pressure or under-pressure in that space.

Also, the cabinet is further arranged with at least one gasket for abutting, upon closing the cabinet door, the at least one partitioning means to said cabinet door. Furthermore, the at least one gasket abuts the at least one partitioning means which partitions the at least one first sub-compartment and the at least one second sub-compartment to said cabinet door. Thus, at least that or those partitioning means which partitions the at least one second sub-compartment from the at least one first sub-compartment, abuts or abut the cabinet door by means of the at least one gasket, upon closing the cabinet door. When the cabinet door is closed, the at least one gasket is in an abutting position with both the cabinet door and the partitioning means thereby hindering, at the cabinet door, fluid to pass between the at least first and second sub-compartments. Thus, when the cabinet door is closed, the at least one partitioning means, and the at least one gasket provide a fluid hindering effect at least along that or those partitioning means provided between the at least one first sub-compartment and the at least one second sub-compartment, where the partitioning means faces the closed cabinet door. In other words, fluid is hindered to enter the at least one second sub-compartment from adjacent sub-compartments at the region where the partitioning means faces the closed cabinet door.

In the case where the cabinet is arranged with two or more partitioning means, i.e. the compartment is partitioned into three or more sub-compartments, gaskets may be arranged for abutting each of the partitioning means to said cabinet door when closed. It is also understood that gaskets may be arbitrarily arranged as long as the gasket or gaskets at least abuts the partitioning means of the at least one second sub-compartment to the closed cabinet door.

The term "gasket" should, in this context, be construed as an element for making a joint fluid-tight or at least hinder fluid to pass the joint. Thus, herein the gasket is used for making the joint between the door and the partitioning means. The gasket is preferably an elastomeric strip, border, edging or the like.

Thus, the present invention is based on the idea of using at least one gasket in combination with at least one partitioning means which partitions the compartment into sub-compartments which are in fluid communication. The use of the gasket in combination with said partitioning means makes it possible to control a distribution of refrigerating fluid throughout said compartment in an advantageously accurate and reliable manner. Thereby, the discharge of the cooling fluid from the cooling system will be supplied to the compartment of the cabinet with a minimized leakage to at least the second sub-compartment or sub-compartments at the cabinet door when closed. This minimization of leakage will ensure that the at least one first sub-compartment into which cooling fluid is discharged will be supplied with a proper amount of cooling fluid whereby an accurate and reliable refrigeration of each sub-compartment is achieved. Also, since the at least one second sub-compartment, via which fluid is exhausted from, is partitioned from the at least one first sub-compartment, via which cooling fluid is discharged, any unwanted "short-circuiting" flow from the fluid outlet directly to the fluid inlet at the cabinet door is reduced.

According to an embodiment of the invention, the at least two sub-compartments may be vertically displaced, i.e. provided on top of each other within the cabinet. In this embodiment, the at least one partitioning means for partitioning the compartment into at least two sub-compartments are arranged horizontally. It is understood that the number of sub-compartments may be varied dependent on the size of the electronic equipment to be positioned therein. The size of the sub-compartment is adapted to the size of the electronic equipment unit to be positioned therein. It is also understood that the sub-compartments within the same cabinet may be of different sizes.

Alternatively, the at least two sub-compartments may be horizontally displaced, i.e. provided side-by-side within the cabinet. In this embodiment, the at least one partitioning means for partitioning the compartment into at least two sub-compartments may be arranged vertically.

Alternatively, any combination of vertical and horizontal displacement of the at least two sub-compartments within the cabinet is also feasible. As an example, at least two sub-compartments may be horizontally displaced, i.e. provided side-by-side within an upper portion of the cabinet whereas in a lower portion of the cabinet, at least two sub-compartments may be vertically displaced, i.e. provided on top of each other.

It is also understood that the fluid outlet and fluid inlet are displaced in analogy to the displacement of the sub-compartments, e.g. that a cabinet having vertically displaced sub-compartments is provided with vertically displaced fluid outlets.

Analogously, in an embodiment where the at least two sub-compartments are horizontally displaced, the fluid outlet openings may be horizontally displaced such that the relative positions between the fluid outlet openings arranged in the cabinet door at positions facing a first of at least two sub-compartments and the at least one first sub-compartment is substantially identical to the relative positions between the fluid outlet openings arranged in the cabinet door at positions facing a second of at least two sub-compartments and the at least one second sub-compartment.

According to an embodiment, the fluid outlet comprises a plurality of fluid outlet openings which are arranged in the cabinet door at positions facing the at least one first sub-compartment. By the plurality of fluid outlet openings, the discharge of cooling fluid via the fluid outlet into the first sub-compartment is improved. One aspect of the improvement is that the cooling fluid may be discharged first after the fluid has passed within the cabinet door to the openings facing the at least one first sub-compartment.

Another aspect of the improvement is that a plurality of fluid outlet openings divides the discharge into a plurality of small discharge flows which spread the discharge into the at least one first sub-compartment. The size and the formation of the fluid outlet openings may be formed and/or arranged to achieve a predetermined spread and velocity of the discharged cooling fluid. The realization of the fluid outlet openings in the cabinet door may be holes, louvers, grilles, gratings or the like.

In an embodiment, the plurality of fluid outlet openings is arranged such that the cooling fluid is evenly distributed into the at least one first sub-compartment. The plurality of fluid outlet openings may be equally spaced apart in the cabinet door within an area facing the at least one first sub-compartment when the door is closed. In other words, the plurality of fluid outlet openings may be symmetrically placed facing the at least one first sub-compartment when the cabinet door is closed. Alternatively, the plurality of fluid outlet, openings may be arranged such that they face an intermediate space, i.e. the space between the partitioning means and the electronic equipment, of the sub-compartment which is not occupied by electronic equipment, thereby ensuring that the discharged cooling fluid may easily enter and penetrate the at least one first sub-compartment. One benefit of an evenly distributed cooling fluid is to provide a uniform cooling of the sub-compartment. More specifically, the distribution may provide a homogeneous cooling temperature in the at least one sub-compartment, avoiding diverging temperature conditions within the sub-compartment. Another benefit of an evenly distributed cooling fluid is the enhanced possibility of an evenly distributed flow through the sub-compartments, thereby avoiding fluid convection which may worsen the cooling performance of the cabinet.

Moreover, the plurality of fluid outlet openings may be arranged such that the cooling fluid is individually distributed into the at least one first sub-compartment. This is advantageous when different electronic equipment or equipment with different sizes are positioned within different sub-compartments of the cabinet body, such that the cooling fluid may be discharged individually into the sub-compartments. As an example, a cooling fluid may be discharged through small holes in one of the at least one first sub-compartment, thereby creating a higher fluid velocity which may for example be in adaptation for the electronic equipment provided in that sub-compartment. In another of the at least one first sub-compartment, a cooling fluid may be discharged through big holes, thereby creating a lower fluid velocity, which may for example be in adaptation for the electronic equipment provided in that sub-compartment.

In an embodiment, the fluid inlet comprises at least one fluid inlet opening arranged in the cabinet door at a position facing the at least one second sub-compartment. This embodiment further enhances the exhausting effect at the fluid inlet.

According to an embodiment, the total area of the plurality of fluid outlet openings is less than that of the at least one fluid inlet opening. This will increase the fluid velocity from the outlet openings into the sub-compartments.

In an embodiment, the at least one first sub-compartment is arranged at one end of the compartment and the at least one second sub-compartment arranged at an opposite end, thereby allowing fluid to flow from one end of the compartment to the opposite end thereof. By this arrangement, the distribution of cooling fluid throughout the compartment is thereby enhanced even further. The fluid inlet and fluid outlet are thus also arranged at opposite ends of the door.

According to an embodiment, the at least one partitioning means provides a hermitical partitioning at least at the end of the at least one partitioning means facing the cabinet door. Thus, at least that portion of the at least one partitioning means which is adjacent to the closed cabinet door provides an hermetical partitioning between the thereof partitioned sub-compartments. The hermetical partitioning hinders any fluid communication to pass between two adjacent sub-compartments at the cabinet door. By this, any leakage between the sub-compartments at the door is reduced even further, thereby enhancing the cooling and refrigeration performance of the cabinet.

In an embodiment, the sub-compartments are in fluid communication along a rear side of the compartment opposite the access opening. This means that each flow from all sub-compartments are reassembled along a rear side, thereby collecting the individual flows from each and every sub-compartment before entering a final sub-compartment which forwards the collected or gathered flow from the rear side of the compartment and through the inlet into the cooling system at a front side. This rear side fluid communication ensures that the cooling flow passes the compartment from the front side, i.e. the side where the door encloses the access opening, to the backside, thereby enhancing the distribution of cooling fluid throughout the compartment even further.

In an embodiment, the at least one gasket may be attached to the at least one partitioning means for abutting the cabinet door upon closure thereof. This is advantageous in the cases cabinet doors need to be replaced, as the replacing cabinet doors may not have to be provided with any gasket.

Alternatively, the at least one gasket may be attached to the cabinet door for abutting the at least one partitioning means upon closure of the cabinet door. This arrangement may be preferred when loading or unloading the cabinet with electronic equipment, as the attachment of the gasket to the door instead of on the partitioning means may provide an easier access to the opening of the cabinet.

In yet another embodiment, the at least one gasket comprises at least a first gasket element attached to the cabinet door and a second gasket element attached to the at least one partitioning means, wherein the first gasket element and the second gasket element are arranged to co-operate with each other upon closure of the cabinet door. Thus, when the door is closed, the first gasket element and the second gasket element are in a fluid-tight contact with each other.

According to an embodiment, the cabinet is arranged with partitioning means for partitioning the compartment into a plurality of sub-compartments being in fluid communication, and wherein the fan exhausts fluid via one sub-compartment and discharges cooling fluid into all other of said plurality of sub-compartment. Thus, the fan of the cooling system discharges cooling fluid via the fluid outlet into all of sub-compartments except one sub-compartment, which fluid is exhausted via. In other words, fluid is exhausted via one sub-compartment and cooling fluid is discharged into all of the other sub-compartments of the plurality of sub-compartments. This further enhances the distribution of refrigerating fluid to all parts of the compartment during operation.

In an embodiment, the cabinet is arranged with at least two compartments which are isolated from each other upon closure of the cabinet door. According to this embodiment, the at least two compartments may be have climates substantially independent of each other. This may have the further advantage that different electronic equipment having different operational temperature intervals may be positioned in separated compartments, thereby providing the possibility of a more selected climate control, e.g. by providing a first temperature within a first compartment and a second temperature in a second compartment, the first and the second temperatures being different.

### BRIEF DESCRIPTION OF THE DRAWINGS

These and other aspects of the present invention will now be described in more detail, with reference to the appended drawings, wherein:
Fig. 1 is a front view of a cabinet with the cabinet door open;
Fig. 2 is a side cross-sectional view of a cabinet with the cabinet door closed according to an embodiment of the present invention;
Fig. 3 is a perspective view of a cabinet with the cabinet door open; and
Fig. 4 is a perspective view of a cabinet with the cabinet doors open.

### DETAILED DESCRIPTION

In the following description, the present invention is described with reference to a cabinet for refrigerating electronic equipment positioned within a compartment of a cabinet body.

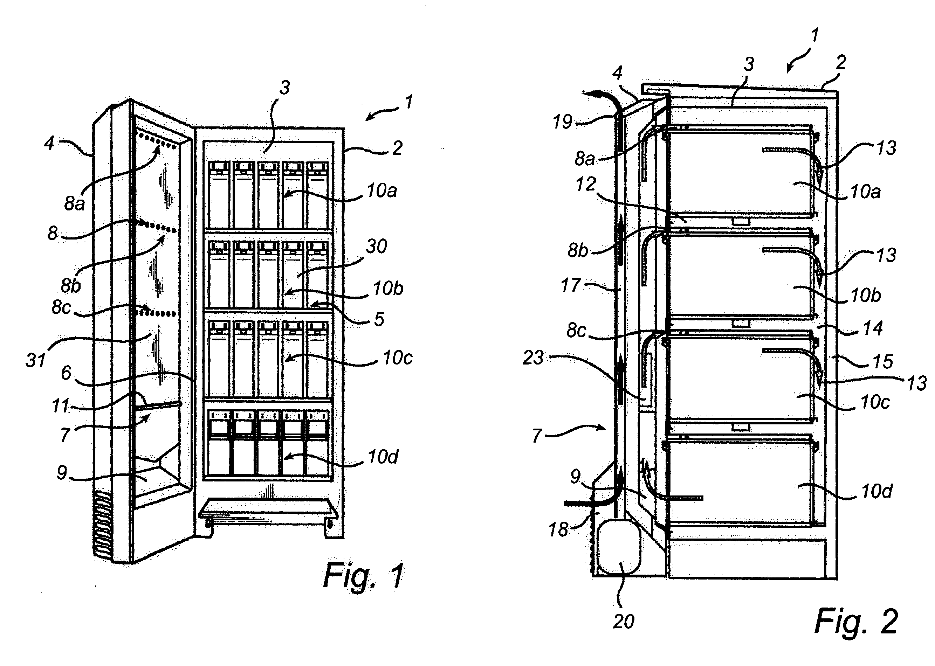

Referring to Fig. 1, a cabinet 1 for refrigerating electronic equipment is shown. The cabinet 1 comprises a cabinet body 2, defined by a top portion, a bottom portion, a back portion and two side portions, which together form a vertically elongated rectangular parallelepiped. The isolation of the cabinet body 2 is adapted for an external, outdoor use, as the cabinet body 2 is typically constructed to be weatherproof so as to minimize the risk of damage of the electronic equipment positioned therein. The cabinet body 2 encloses a compartment 3, wherein the electronic equipment is positioned.

A cabinet door 4 for closing or opening an access opening 5 is vertically hinged on a vertically elongated edge 6 between a side portion and the access opening 5 of the cabinet body 2. The cabinet door 4 which opens in a clockwise direction and closes in a counter-clockwise direction, is shown in Fig. 1 in an open position. Arranged in the cabinet door 4 is a cooling system 7 (not illustrated) in fluid communication with the compartment 3. The cooling system 7 is provided behind a plate 31 in the cabinet door 4, through which plate 31 the fluid communication is realized by a fluid outlet 8. The fluid outlet 8 is arranged as circular holes, the holes providing a fluid communication between the cooling system 7 and the compartment 3. The circular holes are distributed horizontally in three rows with holes arranged in an upper row 8a, a center row 8b and a lower row 8c. The rows are separated vertically, wherein the upper row 8a is provided at the top of the cabinet door 4, the lower row 8c is provided in the approximate center of the cabinet door 4, and the center row 8b is provided approximately between the upper row 8a and the lower row 8c. A fluid inlet 9 is arranged at the base of the cabinet door 4, the fluid inlet 9 providing a fluid communication between the cooling system 7 and the compartment 3. The fluid inlet 9 is an opening defined by the plate 31 and an interior surface (not indicated) of the door 4. The inlet is substantially rectangular and elongates horizontally along the width of the door. The base of the rectangle is horizontal, whereas the top of the rectangle is triangular-shaped, yielding a slimmer waist at the center of the rectangle to form an hourglass shape. The triangular shape of the plate 31 concentrates the possible formation of condensed fluid from the cooling system 7 such that a drainage of the condensed fluid is facilitated.

A plurality of batteries 30 is arranged in the compartment 3 in four vertically separated sub-compartments, each sub-compartment being provided with horizontally arranged batteries. The sub-compartments are arranged as an upper sub-compartment 10a, an upper center sub-compartment 10b, a lower center sub-compartment 10c and a lower sub-compartment 10d. The upper sub-compartment 10a is provided at the top of the compartment 3, wherein the upper center sub-compartment 10b is provided between the approximate center of the compartment 3 and the upper sub-compartment 10a, the lower center sub-compartment 10c is provided between the approximate center of the compartment 3 and the lower sub-compartment 10d, and the lower sub-compartment 10d is provided at the base of the compartment 3.

A horizontally mounted gasket 11 is provided on the interior of the cabinet door 4 such that upon closing the cabinet door 4, the gasket 11 abuts horizontally the mounted partitioning means 12, thereby hindering a fluid to pass the partitioning means 12 at the cabinet door 4.

Fig. 2 shows a side cross-sectional view of the cabinet 1 wherein the cabinet door 4 of the cabinet body 2 is closed, thereby providing a hermetical enclosure of the interior of the cabinet 1 from the outside ambience. Within the cabinet 1 the fluid passes a circulating fluid path 13. In the cabinet door 4, the path 13 elongates vertically from the base of the cabinet door 4 to the top of the door 4. From the cabinet door 4, the path is divided from the three vertically separated sets of fluid outlet openings 8a, 8b, 8c between the cooling system 7 and the compartment 3. The circulating fluid path 13 extends from the outlet 8 into the three upper sub-compartments 10a, 10b, 10c arranged in the compartment 3. The sub-compartments 10a, 10b, 10c, 10d are separated vertically by the partitioning means 12, the sub-compartments 10a, 10b, 10c, 10d and the partitioning means 12 extending horizontally from the fluid outlet 8 to a vertically elongated rear space portion 14, adjacent to the back portion 15 of the cabinet body 2. The partitioning means comprise hereby shelves. The three sub-compartments 10a, 10b, 10c provide a divided fluid path 13, passing from the fluid outlet 8 to the rear space portion 14. The divided fluid path 13, substantially parallel to an axis between a sub-compartment inlet and a sub-compartment outlet, is reassembled at the rear space portion 14, wherein the circulating fluid path 13 is directed downwards. The fourth sub-compartment 10d, provided at the base of the cabinet 1, directs the fluid path 13 from the rear space portion 14 towards the fluid inlet 9.

The cooling system is provided with a heat exchanging device (not shown) which is arranged in the cabinet door 4. The heat exchanging device is arranged in the door for exchanging heat from the compartment to a vertically elongated duct 17 provided along an outer portion of the cabinet door 4. The duct 17 elongates parallel to the part of the circulating fluid path 13 within the cabinet door 4, the duct 17 and the path 13 being separated. A duct inlet 18 is provided at the base of the cabinet door 4, providing a fluid communication between the outside ambience and the base of the duct 17. A duct outlet 19 is provided at the top of the cabinet door 4, providing a fluid communication between the top of the duct 17 and the outside ambience. A compressor 20 is provided in the cabinet door 4 at the base of the duct inlet 18.

The part of the circulating fluid path 13 within the cabinet door 4 passes the heat exchanging device which cools the fluid from the inlet 9. A fan 23 is provided which sucks the cooling fluid from below and blows the fluid upwards, such that the cooling fluid is discharged through the fluid outlet openings 8a, 8b and 8c, provided above the fan 23. Thus, the fluid is distributed along the circulating fluid path 13 from the apertures 8a, 8b, 8c between the cooling system 7 and the compartment 3. The fluid passes through the sub-compartments 10a, 10b and 10c to the rear space portion 14, and is reassembled at the rear space portion 14, wherein the fluid is directed downwards. From the base of the rear space portion 14 towards the fluid inlet 9, the fluid passes through the fourth sub-compartment 10d and via the fluid inlet opening 9.

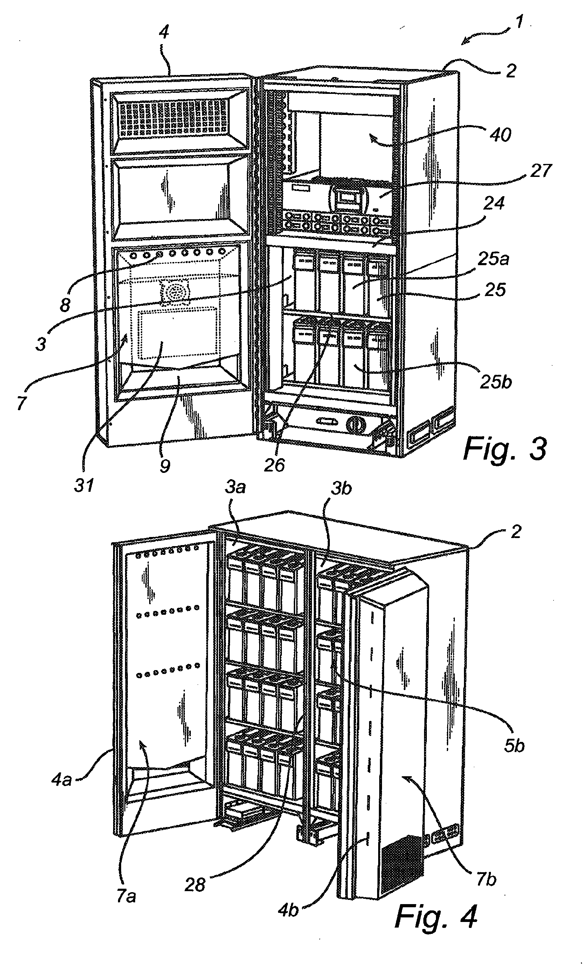

In Fig. 3, a cabinet 1 is shown in a perspective view with the cabinet door 4 open. The cabinet body 2, shaped as a rectangular parallelepiped, has an interior which is divided by a horizontally mounted shelf 24 into a lower compartment 3 and an additional upper compartment 40 provided above the compartment 3. The shelf 24 is provided approximately in the middle of the cabinet body 2. In the compartment 3, batteries 25 are arranged in two vertically separated sub-compartments 25a and 25b, each sub-compartment being provided with 4 batteries arranged along a horizontal axis. The sub-compartments 25a, 25b are partitioned by a horizontally elongated shelf 26.

A cooling system 7 is provided within the lower part of the cabinet door 4, the system being in fluid communication with the compartment 3 when the cabinet door 4 is closed. The communication is realized by a fluid outlet 8 and a fluid inlet 9, wherein the fluid outlet 8 is arranged as circular holes in the plate 31, the holes providing a fluid communication between the cooling system 7 and the lower compartment 3. The holes are distributed horizontally in a row at the approximate center of the cabinet door 4. The inlet 9 is arranged at the base of the cabinet door 4, the inlet 9 providing a fluid communication between the cooling system 7 and the compartment 3 when the cabinet door is closed. In the upper part of the cabinet body 2, the additional upper compartment 40 is provided with another type of electronic equipment 27. The upper and the lower compartments 3a, 3b are separated by the shelf 24, thereby providing two independently systems. For example, the compartment 3 provides a refrigerating compartment whereas the additional upper compartment 40 is a non-refrigerating compartment hermetically sealed, when the door is closed, from the lower compartment 3.

Shown in a perspective view in Fig. 4 is a cabinet wherein two compartments 3a, 3b are provided side-by-side in the cabinet body 2. A vertically arranged wall 28 in the center of the cabinet separates the two compartments 3a, 3b.

Two cabinet doors 4a, 4b are vertically hinged on the cabinet body 2 at opposite sides of the access openings 5a and 5b, respectively. The leftmost door 4a opens in a clockwise direction, and closes in a counter-clockwise direction. Analogously, the rightmost door 4b opens in a counter-clockwise direction, and closes in a clockwise direction. The two doors 4a, 4b close at the vertical wall portion 28. The two doors 4a, 4b in Fig. 4 are both shown in an open position. Provided within each cabinet door 4a, 4b is a cooling system such that the cabinet provides two cooling systems 7a, 7b. By this, two compartments 3a, 3b with individual refrigerating operations may be provided, adapted to provide an improved cabinet refrigeration.

Even though the invention has been described with reference to specific exemplifying embodiments thereof, many different alterations, modifications and the like will become apparent for those skilled in the art. The described embodiments are therefore not intended to limit the scope of the invention, as defined by the appended claims. For example, the shape of the fluid inlet 9 and the fluid outlet 8 may take on any other geometrical shapes than those depicted. Louvers, grilles, gratings or the like are all possible embodiments of the fluid inlet 9 and fluid outlet 8. Moreover, the rectangular parallelepiped shape of the cabinet body 2 may instead be of e.g. cubic or cylindric shape. Furthermore, the door 4 may be opened clockwise or anti-clockwise, upwards or downwards, dependent on how the door is hinged to the cabinet body 2. Alternatively, the door may instead be replaced by a closing means for closing the access opening 5, the closing means being provided with fastening means such as screws, locking means or the like.

Further, any number and placement of sub-compartments within a cabinet body 2 may be feasible. As an example, a cabinet body 2 may have the structure of the body depicted in Fig. 4 with two compartments 3a, 3b side-by-side, but wherein one or both of the compartments may be divided as depicted in Fig. 3 with a horizontally mounted shelf 24.

The fan 23 in Fig. 2, may alternatively be substituted by a turbine, pump, or the like, to generate a flow of the fluid within the cabinet door 4. Moreover, instead of a cabinet body 2 with the shape of a vertically elongated rectangular parallelepiped, the parallelepiped may be elongated horizontally. In this embodiment, the fluid outlet 8 may instead of being provided as rows be provided as columns, and, consequently, instead of being separated vertically be separated horizontally. In combination, or independently of this embodiment, the vertically hinged door 4 may instead be hinged horizontally on a horizontally elongated edge between the top portion and the access opening 5 of the cabinet body 2.

Furthermore, the gasket 11 as disclosed in Fig. 1 may not only be provided in the cabinet door 4 but also on the partitioning means 12 at the access opening 5 such that a first gasket element provided on the door 4 and a second gasket element provided on the partitioning means 12 abut upon closing the door 4 such that a fluid is hindered to pass the partitioning means 12.

Moreover, any other heat exchanger than in the embodiment disclosed in Fig. 2 may be feasible. As an alternative, parts of the disclosed heat exchanger elements or additional auxiliary elements may be provided outside the cabinet body 2.

## Claims

1. A cabinet (1) for refrigerating electronic equipment positioned in a compartment (3) of a cabinet body (2) of the cabinet, said cabinet further being arranged with:
a cabinet door (4) for closing an access opening (5) to said compartment; and
a cooling system (7) arranged in the cabinet door and comprising a fan (23);
**characterized in that**:
said cabinet is further arranged with at least one partitioning means (12) for partitioning the compartment into at least two sub-compartments (10a, 10b, 10c, 10d), wherein the at least two sub-compartments are in fluid communication;
the cooling system is in fluid communication with the compartment via a fluid outlet (8) and a fluid inlet (9), wherein the fan is arranged to discharge cooling fluid via the fluid outlet into at least a first sub-compartment of said at least two sub-compartments and to exhaust fluid via at least a second sub-compartment of said at least two sub-compartments through the fluid inlet;
and said cabinet is further arranged with at least one gasket (11) for abutting, upon closing the cabinet door, the at least one partitioning means and said cabinet door, thereby hindering fluid to pass between the sub-compartments at the cabinet door.

2. The cabinet according to claim 1, wherein the fluid outlet comprises a plurality of fluid outlet openings (8a, 8b, 8c) which are arranged in the cabinet door at positions facing the at least one first sub-compartment of said at least two sub-compartments.

3. The cabinet according to claim 2, wherein the plurality of fluid outlet openings are arranged such that the cooling fluid is evenly distributed into the at least one first sub-compartment of said at least two sub-compartments.

4. The cabinet according to any of the claims 1 to 3, wherein the fluid inlet comprises at least one fluid inlet opening which is arranged in the cabinet door at a position facing the at least one second sub-compartment of said at least two sub-compartments.

5. The cabinet according to claim 4, wherein the total area of the plurality of fluid outlet openings is less than that of the at least one fluid inlet opening.

6. The cabinet according to any of the claims 1 to 5, wherein the at least one first sub-compartment of said at least two sub-compartments are arranged at one end of the compartment and the at least one second sub-compartment of said at least two sub-compartment is arranged at an opposite end, thereby allowing fluid to flow from one end of the compartment to the opposite end thereof.

7. The cabinet according to any of the claims 1 to 6, wherein the at least one partitioning means provides a hermitical partitioning at least at the end of the at least one partitioning means facing the cabinet door.

8. The cabinet according to any of the claims 1 to 7, wherein the at least two sub- compartments are in fluid communication along a rear side of the compartment opposite the access opening.

9. The cabinet according to any of the claims 1 to 8, wherein the at least one gasket is attached to the at least one partitioning means for abutting the cabinet door upon closure thereof.

10. The cabinet according to any of the claims 1 to 8, wherein the at least one gasket is attached to the cabinet door for abutting the at least one partitioning means upon closure of the cabinet door.

11. The cabinet according to any of the claims 1 to 8, wherein the at least one gasket comprises at least a first gasket element attached to the cabinet door and a second gasket element attached to the at least one partitioning means, wherein the first gasket element and the second gasket element are arranged to co-operate with each other upon closure of the cabinet door.

12. The cabinet according to any of the claims 1 to 11, wherein said cabinet is arranged with at least one partitioning means for partitioning the compartment into a plurality of sub-compartments being in fluid communication, and wherein the fan exhausts fluid via one second sub-compartment and discharges cooling fluid into all other of said plurality of sub-compartment.

13. The cabinet according to any of the claims 1 to 12, wherein the cabinet is arranged with at least two compartments which are isolated from each other upon closure of the cabinet door.

## Patentansprüche

1. Schrank (1) zum Kühlen elektronischer Ausrüstungen, die in einer Kammer (3) eines Schrankgehäuses (2) des Schranks angeordnet sind, wobei der Schrank ferner versehen ist mit:
einer Schranktür (4) zum Verschließen einer Zugangsöffnung (5) zu der Kammer; und
einem Kühlsystem (7), das in der Schranktür angeordnet ist und einen Ventilator (23) umfasst;
**dadurch gekennzeichnet, dass**:
der Schrank ferner mit mindestens einem Unterteilmittel (12) zum Unterteilen der Kammer in mindestens zwei Unterkammern (10a, 10b, 10c, 10d) versehen ist, wobei die mindestens zwei Unterkammern in Fluidkommunikation stehen;
das Kühlsystem mit der Kammer über einen Fluidauslass (8) und einen Fluideinlass (9) in Fluidkommunikation steht, wobei der Ventilator vorgesehen ist, um Kühlfluid über den Fluidauslass in mindestens eine erste Unterkammer der mindestens zwei Unterkammern auszutragen und um Fluid durch den Fluideinlass über mindestens eine zweite Unterkammer der mindestens zwei Unterkammern abzusaugen;
und der Schrank ferner mit mindestens einer Dichtung (11) zum Anliegen an dem mindestens einen Unterteilmittel und der Schranktür, nach dem Schließen der Schranktür, versehen ist, wodurch verhindert wird, dass Fluid an der Schranktür zwischen den Unterkammern übertritt.

2. Schrank nach Anspruch 1, wobei der Fluidauslass mehrere Fluidauslassöffnungen (8a, 8b, 8c) umfasst, die in der Schranktür an Positionen angeordnet sind, welche der mindestens einen ersten Unterkammer der mindestens zwei Unterkammern zugewandt sind.

3. Schrank nach Anspruch 2, wobei die mehreren Fluidauslassöffnungen derart angeordnet sind, dass das Kühlfluid gleichmäßig in die mindestens eine erste Unterkammer der mindestens zwei Unterkammern verteilt wird.

4. Schrank nach einem beliebigen der Ansprüche 1 bis 3, wobei der Fluideinlass mindestens eine Fluideinlassöffnung umfasst, die in der Schranktür an einer Position angeordnet ist, welche der mindestens einen zweiten Unterkammer der mindestens zwei Unterkammern zugewandt ist.

5. Schrank nach Anspruch 4, wobei die gesamte Fläche der mehreren Fluidauslassöffnungen kleiner als jene der mindestens einen Fluideinlassöffnung ist.

6. Schrank nach einem beliebigen der Ansprüche 1 bis 5, wobei die mindestens eine erste Unterkammer der mindestens zwei Unterkammern an einem Ende der Kammer angeordnet ist und die mindestens eine zweite Unterkammer der mindestens zwei Unterkammern an einem entgegengesetzten Ende angeordnet ist, wodurch ermöglicht wird, dass Fluid von einem Ende der Kammer zu ihrem entgegengesetzten Ende strömt.

7. Schrank nach einem beliebigen der Ansprüche 1 bis 6, wobei das mindestens eine Unterteilmittel eine hermetische Unterteilung mindestens an dem der Schranktür zugewandten Ende des mindestens einen Unterteilmittels vorsieht.

8. Schrank nach einem beliebigen der Ansprüche 1 bis 7, wobei die mindestens zwei Unterkammern entlang einer der Zugangsöffnung entgegengesetzten, hinteren Seite der Kammer in Fluidkommunikation stehen.

9. Schrank nach einem beliebigen der Ansprüche 1 bis 8, wobei die mindestens eine Dichtung an dem mindestens einen Unterteilmittel befestigt ist, um nach dem Schließen der Schranktür an dieser anzuliegen.

10. Schrank nach einem beliebigen der Ansprüche 1 bis 8, wobei die mindestens eine Dichtung an der Schranktür befestigt ist, um nach dem Schließen der Schranktür an dem mindestens einen Unterteilmittel anzuliegen.

11. Schrank nach einem beliebigen der Ansprüche 1 bis 8, wobei die mindestens eine Dichtung mindestens ein erstes Dichtungselement, das an der Schranktür befestigt ist, und ein zweites Dichtungselement, das an dem mindestens einen Unterteilmittel befestigt ist, umfasst, wobei das erste Dichtungselement und das zweite Dichtungselement angeordnet sind, um nach dem Schließen der Schranktür miteinander zusammenzuwirken.

12. Schrank nach einem beliebigen der Ansprüche 1 bis 11, wobei der Schrank mit mindestens einem Unterteilmittel zum Unterteilen der Kammer in mehrere Unterkammern, die in Fluidkommunikation stehen, versehen ist und wobei der Ventilator Fluid über eine zweite Unterkammer absaugt und Kühlfluid in alle anderen der mehreren Unterkammern austrägt.

13. Schrank nach einem beliebigen der Ansprüche 1 bis 12, wobei der Schrank mit mindestens zwei Kammern versehen ist, die nach dem Schließen der Schranktür voneinander getrennt sind.

## Revendications

1. Armoire (1) pour la réfrigération d'équipements électroniques positionnés dans un compartiment (3) d'un corps d'armoire (2) de l'armoire, ladite armoire étant en outre conçue avec :
une porte d'armoire (4) destinée à fermer une ouverture d'accès (5) audit compartiment ; et
un système de refroidissement (7) installé dans la porte d'armoire et comprenant un ventilateur (23) ;
**caractérisée en ce que**
ladite armoire est en outre conçue avec au moins un moyen de division (12) destiné à diviser le compartiment en au moins deux sous-compartiments (10a, 10b, 10c, 10d), les au moins deux sous-compartiments étant en communication fluidique ;
le système de refroidissement est en communication fluidique avec le compartiment par le biais d'une sortie de fluide (8) et d'une entrée de fluide (9), le ventilateur étant conçu pour décharger du fluide de refroidissement par le biais de la sortie de fluide dans au moins un premier sous-compartiment parmi lesdits au moins deux sous-compartiments, et pour évacuer du fluide par le biais d'au moins un deuxième sous-compartiment parmi lesdits au moins deux sous-compartiments par le biais de l'entrée de fluide ;
et ladite armoire étant en outre conçue avec au moins un joint d'étanchéité (11) destiné à buter contre l'au moins un moyen de division et ladite porte d'armoire lors de la fermeture de la porte d'armoire, empêchant ainsi le fluide de passer entre les sous-compartiments au niveau de la porte d'armoire.

2. Armoire selon la revendication 1, dans lequel la sortie de fluide comprend une pluralité d'ouvertures de sortie de fluide (8a, 8b, 8c) arrangées dans la porte d'armoire, dans des positions tournées vers l'au moins un premier sous-compartiment parmi lesdits au moins deux sous-compartiments.

3. Armoire selon la revendication 2, dans lequel la pluralité d'ouvertures de sortie de fluide est arrangée de manière à ce que le fluide de refroidissement soit distribué uniformément dans l'au moins un premier sous-compartiment parmi lesdits au moins deux sous-compartiments.

4. Armoire selon l'une quelconque des revendications 1 à 3, dans laquelle l'entrée de fluide comprend au moins une ouverture d'entrée de fluide arrangée dans la porte d'armoire, dans une position tournée vers l'au moins un deuxième sous-compartiment parmi lesdits au moins deux sous-compartiments.

5. Armoire selon la revendication 4, dans laquelle l'aire totale de la pluralité d'ouvertures de sortie de fluide est inférieure à celle de l'au moins une ouverture d'entrée de fluide.

6. Armoire selon l'une quelconque des revendications 1 à 5, dans laquelle l'au moins un premier sous-compartiment parmi lesdits au moins deux sous-compartiments est arrangé à une extrémité du compartiment, et l'au moins un deuxième sous-compartiment parmi lesdits au moins deux sous-compartiments est arrangé à une extrémité opposée, permettant ainsi au fluide de s'écouler d'une extrémité du compartiment vers l'extrémité opposée de celui-ci.

7. Armoire selon l'une quelconque des revendications 1 à 6, dans laquelle l'au moins un moyen de division assure une division hermétique au moins à l'extrémité de l'au moins un moyen de division qui est tournée vers la porte d'armoire.

8. Armoire selon l'une quelconque des revendications 1 à 7, dans laquelle les au moins deux sous-compartiments sont en communication fluidique le long d'un côté arrière du compartiment à l'opposé de l'ouverture d'accès.

9. Armoire selon l'une quelconque des revendications 1 à 8, dans laquelle l'au moins un joint d'étanchéité est relié à l'au moins un moyen de division pour buter contre la porte d'armoire lors de la fermeture de celle-ci.

10. Armoire selon l'une quelconque des revendications 1 à 8, dans laquelle l'au moins un joint d'étanchéité est relié à la porte d'armoire pour buter contre l'au moins un moyen de division lors de la fermeture de la porte d'armoire.

11. Armoire selon l'une quelconque des revendications 1 à 8, dans laquelle l'au moins un joint d'étanchéité comprend au moins un premier élément d'étanchéité relié à la porte d'armoire et un deuxième élément d'étanchéité relié à l'au moins un moyen de division, le premier élément d'étanchéité et le deuxième élément d'étanchéité étant arrangés pour coopérer l'un avec l'autre lors de la fermeture de la porte d'armoire.

12. Armoire selon l'une quelconque des revendications 1 à 11, dans laquelle ladite armoire est conçue avec au moins un moyen de division destiné à diviser le compartiment en une pluralité de sous-compartiments en communication fluidique, et dans laquelle le ventilateur évacue du fluide par le biais d'un deuxième sous-compartiment et décharge du fluide de refroidissement dans tous les autres parmi ladite pluralité de sous-compartiments.

13. Armoire selon l'une quelconque des revendications 1 à 12, dans laquelle l'armoire est conçue avec au moins deux compartiments isolés l'un de l'autre lors de la fermeture de la porte d'armoire.
